# EUROPÄISCHE PATENTSCHRIFT

(11) **EP 1 420 314 B1**
(45) Veröffentlichungstag und Bekanntmachung des Hinweises auf die Patenterteilung: **31.12.2008**
(21) Anmeldenummer: 03026038.4
(22) Anmeldetag: 12.11.2003
(51) Int. Cl.: G05B 19/418

(54) **Verfahren, Vorrichtung, computerlesbares Speichermedium und Computerprogramm-Element zum Überwachen eines Herstellungsprozesses einer Mehrzahl von physikalischen Objekten**
Method, apparatus, data carrier and computer program module for monitoring a production process of multiple physical objects
Procédé, dispositif, support de données et module logiciel pour la surveillance d'un processus de fabrication de plusieurs objects physiques

(30) Priorität: 12.11.2002 DE 10252614
(43) Veröffentlichungstag der Anmeldung: 19.05.2004
(73) Patentinhaber: Infineon Technologies AG, 81669 München (DE)
(72) Erfinder: Märitz, Jörn, 93152 Zeiler-Nittendorf (DE)
(74) Vertreter: Viering, Jentschura & Partner

(56) Entgegenhaltungen:
- US-A- 5 422 724
- US-A1- 2002 062 162
- US-B1- 6 202 037
- US-B1- 6 233 494
- US-B1- 6 427 093

## Beschreibung

Die Erfindung betrifft ein Verfahren, eine Vorrichtung, ein computerlesbares Speichermedium und ein Computerprogramm-Element zum Überwachen von Produktqualitätsdaten in einem Herstellungsprozess.

Bei der Herstellung von Wafern mit hochintegrierten Halbleiterchips werden insbesondere durch die immer weiter steigende Miniaturisierung der Strukturen auf dem Halbleiterchip immer höhere Anforderungen an die für die Herstellung der Halbleiterchips verwendeten Fertigungsanlagen und Herstellungsprozesse auftreten. Die Stabilität und Reproduzierbarkeit sowohl der Fertigungsanlagen als auch der Herstellungsprozesse beeinflussen maßgeblich die Ausbeute und Produktivität im Rahmen der Halbleiterchip-Fertigung. Schon kleine Abweichungen von einem Soll-Verhalten einer Chip-Fertigungsanlage im Rahmen der Produktion können zu einer erheblichen Verschlechterung der Ausbeute, das heißt zu einer erheblichen Erhöhung der Fehlerrate bei den hergestellten Halbleiterchips führen.

Um die Qualität des Herstellungsprozesses und die Qualität der Wafer sicherzustellen, müssen die fertig prozessierten Wafer Testmessungen unterzogen werden. Um den Herstellungsprozess vollständig zu überwachen und zu beurteilen, wäre es nötig jeden einzelnen Wafer, welcher mittels des Herstellungsverfahrens produziert wurde, zu testen und die Qualität des Wafers anschließend zu beurteilen. Dies ist jedoch aufgrund der zeit- und kostenintensiven Testmessungen zum Bestimmen der Qualität der Wafer nicht möglich.

Gemäß dem Stand der Technik behilft man sich, indem man nach Beendigung des Herstellungsprozesses einzelne Wafer als Stichproben aus einem Los von Wafern statistisch, d.h. zufällig ausgewählt. Dieses Verfahren wird üblicherweise als "Statistical Process Control" (SPC) Verfahren bezeichnet. An dieser Stichprobe werden nachfolgend Testmessungen durchgeführt. Im Rahmen der Anmeldung werden diese Testmessungen auch als SPC-Messungen bezeichnet. Anhand der Ergebnisse der Testmessungen wird dann eine Aussage über die Qualität aller Wafer des Loses getroffen. Hierbei wird davon ausgegangen, dass Wafer ausgewählt werden, welche repräsentativ für das gesamte Los sind. Zum Beispiel werden zwei beliebige Wafer des Loses ausgewählt. Man nimmt an, dass die Qualität des gesamten Loses dann um die gemessenen Werte der Qualität schwanken wird. Die so bestimmten Werte gehen sowohl in die Bestimmung des cp-Wertes, welcher eine Aussage über die Breite einer Verteilung der Messwerte ist, oder anders ausgedrückt ein Maß für den kleinstmöglichen Anteil fehlerhafter Einheiten (Wafer) im Prozess, der bei zentrierter Lage der Verteilung erwartet wird, als auch in die Bestimmung des cpk-Wertes ein, welcher ein Wert ist, der angibt, wie zentrisch die Verteilung der Messwerte zu einer vorgegebenen Spezifikation liegt, oder anders ausgedrückt ein Maß für den erwarteten Anteil fehlerhafter Einheiten im Prozess..

Diese Vorgehensweise hat zwar den Vorteil, dass sie schnell und kostengünstig durchzuführen ist, sie weist jedoch den Nachteil auf, dass bei dieser Vorgehensweise die ermittelte Qualität der Wafer Zufälligkeiten unterworfen ist. Wird bei der willkürlichen Auswahl der Stichprobe ein Wafer herangezogen, welcher eine schlechte Qualität aufweist, wird die schlechte Qualität dem gesamten Los zugesprochen. Umgekehrt kann es auch dazu kommen, dass ein gesamtes Los als bestimmte Qualitätskriterien erfüllend klassifiziert wird, wenn zufällig ein qualitativ hochwertiges Exemplar, d.h. ein überdurchschnittlich gut prozessierter Wafer, für die Testmessung zum Bestimmen der Qualität herangezogen wird.

Durch die Schwankungen, welche durch die zufällige Auswahl verursacht werden, ist in dem Verfahren gemäß dem Stand der Technik auch die Bestimmung des cp-Werts und des cpk-Werts nur unbefriedigend möglich.

Somit sind gemäß dem Stand der Technik Qualitätswerte von Wafern und des Herstellungsprozesses statistischen Schwankungen unterworfen, über welche keine Aussagen getroffen werden können. Die Aussage hängt von der zufälligen Auswahl des getesteten Wafer ab. Somit sind auch die cp-Werte des Herstellungsverfahrens und die cpk-Werte der Herstellung Unsicherheiten unterworfen. Um Aussagen über die Stichhaltigkeit der Qualitätsbewertung zu erlangen oder um die Qualitätsbewertung statistisch signifikanter zu gestalten, müsste die Anzahl der Wafer vergrößert werden, welche der Testmessung unterzogen werden.

In [1] wird ein Überblick über Verfahren zum Detektieren von Ausreißern in der Halbleiter-Herstellung gegeben.

Aus [2] ist ein Verfahren zur Reduktion von Zielgebungsfehlern bekannt, welche auftreten, wenn versucht wird unter einer stark vergrößernden Abbildungsvorrichtung verschmutzende Partikel auf einem Wafer zu lokalisieren.

Aus [3] ist ein Qualitätsverwaltungssystem bekannt, bei dem eine Datenbearbeitungseinheit einen von einer Fehlerinspektionsvorrichtung gemessenen Datenwert, wie zum Beispiel Anzahl der Fehler, eine Fläche von jedem Fehler, einen äquivalenten Durchmesser der Fläche usw. derart bearbeitet, dass Indexwerte als bearbeitete Datenwerte errechnet werden, anhand derer eine Beurteilungseinheit beurteilt, ob oder ob nicht eine weitere Prüfung durchgeführt werden soll.

Das Dokument [4] offenbart ein Verfahren zur Messung eines Overlay-Offsets von Wafern, wobei Ausrichtungsdaten eines jeden Wafers gemessen werden und eine Standardabweichung berechnet wird. Falls die Standardabweichung einen vorgegebenen Wert übersteigt, werden nachfolgend alle Wafer eines Loses gemessen, während nur bestimmte Wafer gemessen werden, wenn die Standardabweichung den vorgegebenen Wert nicht übersteigt.

Der Erfindung liegt das Problem zugrunde den cp-Wert und den cpk-Wert eines Loses auf einfache Weise zu bestimmen.

Das Problem wird durch das Verfahren und die Vorrichtung zum Überwachen eines Herstellungsprozesses mit den Merkmalen gemäß den unabhängigen Patentansprüchen gelöst.

Bei einem Verfahren zum Überwachen eines Herstellungsprozesses einer Mehrzahl von physikalischen Objekten, wird eine Analyse unter Verwenden von Werten von mindestens einem Prozessparameter des Herstellungsprozesses der physikalischen Objekte vorgenommen. Als Ergebnis der Analyse werden ein erstes physikalisches Objekt, dessen Prozessparameterwert die Prozessparameterwerte der Mehrzahl physikalischer Objekte charakterisiert und ein zweites physikalisches Objekt, dessen Prozessparameterwert eine vorgegebene Differenz zum Prozessparameterwert des ersten physikalischen Objekts aufweist, derart gekennzeichnet, dass die beiden physikalischen Objekte als Stichprobe für die Überwachung des Herstellungsprozesses herangezogen werden können, d.h. an der Stichprobe können SPC-Messungen zum Überwachen der Qualität des physikalischen Objektes durchgeführt werden. Die beiden physikalischen Objekte werden einer Qualitätsüberprüfungsmessung zum Überprüfen der Qualität der Mehrzahl physikalischer Objekte unterzogen.

Unter einem Prozessparameter ist in diesem Zusammenhang ein Parameter eines Herstellungsprozesses eines physikalischen Objektes zu verstehen. Hierunter fallen zum Beispiel bei der Herstellung eines Wafers die Dejustierung, d.h. die Ungenauigkeit der Positionierung eines Wafers in einer Maschine oder anders ausgedrückt eine Abweichung einer tatsächlichen Position des Wafers in der Maschine von der Sollposition des Wafers in der Maschine, innerhalb eines Positionierungsschrittes, die Temperatur während eines Prozessschrittes, der Gasfluss während eines Prozessschrittes, die Zeitdauer eines Prozessschrittes, der während eines Prozessschrittes herrschende Druck, allgemein alle Ventilstellungen, eine Waferträger-Geschwindigkeit und ein Waferträger-Andruck. Andere Prozessparameter in einer Lithographie sind zum Beispiel verschiedene Justagegrößen, eine Fokussierung oder eine Dosis. Diese Prozessparameter werden ständig während des Herstellungsprozesses gemessen und stehen für eine Analyse bereit.

Die Analyse kann eine statistische Analyse sein. Sie kann aber auch Einzelwerte untersuchen oder einfache Statements, z.B. ob ein physikalisches Objekt eine bestimmte Anforderung genügt oder nicht genügt (good - no good), auswerten.

Die Vorrichtung zum Überwachen eines Herstellungsprozesses eines physikalischen Objektes weist mindestens einen Prozessor auf, der so eingerichtet ist, dass die oben beschriebenen Verfahrensschritte durchgeführt werden können.

In einem computerlesbaren Speichermedium ist ein Bearbeitungsprogramm zum Überwachen eines Herstellungsprozesses eines physikalischen Objektes gespeichert, welches Bearbeitungsprogramm, wenn es von einem Prozessor ausgeführt wird, die oben beschriebenen Verfahrensschritte aufweist.

Ein Computerprogramm-Element zum Überwachen eines Herstellungsprozesses eines physikalischen Objektes, weist die oben beschriebenen Verfahrensschritte auf, wenn es von einem Prozessor ausgeführt wird.

Die Erfindung kann sowohl mittels eines Computerprogramms, d.h. einer Software, als auch mittels einer oder mehrerer spezieller elektrischer Schaltungen, d.h. in Hardware oder in beliebig hybrider Form, d.h. mittels Software-Komponenten und Hardware-Komponenten, realisiert werden.

Die Erfindung weist den Vorteil auf, dass mittels der Analyse der Prozessdaten ein Auswahlkriterium für eine Stichprobenauswahl zur Verfügung gestellt wird, mittels welchem eine Stichprobe bestimmt werden kann, welche repräsentativ für das gesamte Los ist. Es wird nicht wie im Stand der Technik willkürlich eine Stichprobe aus dem Los entnommen, welche Stichprobe einer SPC-Messung unterzogen wird, sondern es werden gezielt solche Stichproben entnommen, deren Produktqualität für das gesamte Los typisch ist. Das Verfahren erlaubt somit eine aktive Stichprobenauswahl aufgrund von Prozessdaten. Mittels des Verfahrens kann somit eine Stichprobe, an welcher eine SPC-Messung zum Ermitteln der Qualität durchgeführt wird, bestimmt werden und somit das gesamte Los auf verbesserte Weise charakterisiert werden. Die Aussagekraft der Qualitätsprüfung erhöht sich. Auch kann mittels des erfindungsgemäßen Verfahrens die Auswahl der Stichproben automatisiert werden.

Mittels der zusätzlichen Qualitätsüberprüfungsmessung ist es auf einfache Weise möglich, die Streubreite der Verteilung der Produktqualitäten der physikalischen Objekte eines Loses zu bestimmen. Vorzugweise ist die vorgegebene Differenz die maximal in der Verteilung der Prozessparameter auftretende Differenz. Besonders Vorzugsweise ist die vorgegebene Differenz eine Differenz, welche einer 1σ-Differenz der Verteilung entspricht.

Bevorzugte Weiterbildungen der Erfindung ergeben sich aus den abhängigen Ansprüchen. Die weiteren Ausgestaltungen der Erfindung betreffen das Verfahren und die Vorrichtung zum Überprüfen des Herstellungsprozesses eines physikalischen Objektes, das computerlesbare Speichermedium und das Programm-Element.

Vorzugsweise ist das physikalische Objekt ein Wafer.

Insbesondere bei der Waferherstellung mit ihrer extrem hohen Zahl von Prozessschritten mit sehr hohen Anforderungen an die Genauigkeit der Einstellung der Prozessparameter eignet sich die Erfindung gut, da in diesem Bereich somit erstmals eine automatisierte verbesserte Qualitätskontrolle auf einfache Weise realisiert ist.

In einer bevorzugten Weiterbildung ist die Analyse eine statistische Analyse.

Ferner vorzugsweise werden bei dem erfindungsgemäßen Verfahren die Werte des mindestens einen Prozessparameters beim Herstellen des physikalischen Objektes gemessen.

Die Analyse besteht vorzugsweise in der Ermittlung des Medians der Werte des mindestens einen Prozessparameters.

Der Median einer Verteilung eines Prozessparameters ist besonders geeignet zur Charakterisierung eines Loses, da bei ihm Werte des Prozessparameters, welche stark von den anderen gemessenen Werten des Prozessparametern abweichen, keine Auswirkungen haben. Wafer die für den betreffenden Prozessparameter einen Wert nahe am Median der Verteilung liefern, charakterisieren das betreffende Los besonders gut. Dadurch wird die Aussagekraft einer Qualitätsüberprüfungsmessung vergrößert

Die Analyse kann in der Ermittlung des arithmetischen Mittelwertes der Werte des mindestens einen Prozessparameters bestehen.

Der arithmetische Mittelwert charakterisiert ebenfalls die Verteilung der bei der Herstellung von Wafern eines Loses gemessenen Prozessparametern. Ferner ist er leichter und schneller als der Median zu berechnen.

Mittels des erfindungsgemäßen Verfahrens wird ein Auswahlkriterium bereitgestellt, welches dazu dient repräsentative Wafer eines Loses zu bestimmen. Hierzu wird vorzugsweise der Median einer Verteilung von Messwerten eines Prozessparameters beim Herstellen der einzelnen Wafer eines Loses bestimmt. Wafer bei deren Herstellung der betreffende Prozessparameter einen Wert nahe am Median der Verteilung aller gemessener Werte des Prozessparameters aufweist, charakterisieren das betreffende Los besonders gut. Dadurch wird die Aussagekraft einer Qualitätsüberprüfungsmessung vergrößert.

Soll zusätzlich auch noch eine Schwankungsbreite der Qualitätsverteilung bestimmt werden, so wird neben einer Stichprobe, welche den Median oder den arithmetischen Mittelwert der Verteilung charakterisiert, eine Stichprobe untersucht, welche den Rand der Verteilung der Werte des entsprechenden Prozessparameters charakterisiert. Alternativ kann die Schwankungsbreite auch direkt aus der Verteilung der Werte des Prozessparameters bestimmt werden. Dieses Vorgehen weist den Vorteil auf, dass direkt mittels einer einzelnen zeit- und kostenintensiven Messung an zwei Wafern sowohl der Mittelwert als auch die Breite der Qualitätsverteilung bestimmt werden kann. Weiterhin weist das erfindungsgemäße Verfahren den Vorteil auf, dass auf die aufwendigen SPC-Messungen zum Bestimmen der Qualität der Wafer auch ganz verzichtet werden kann, wenn mittels der aufgenommenen und statistisch ausgewerteten Prozessdaten ersichtlich ist, dass sich keine Abweichungen seit der letzten Qualitätsmessung, welche für ein Wafer desselben Herstellungsverfahrens durchgeführt wurde, ergeben haben.

Als Vorteile des erfindungsgemäßen Verfahrens ergeben sich somit eine Verringerung der Anzahl von Stichproben, an welchen Qualitätsmessungen durchgeführt werden müssen, um die gleiche statistische Aussagekraft zu erhalten. Damit wird eine Verringerung des Maschinenkapazitätsbedarfes, eine höhere Automatisierung der Stichprobenauswahl und eine verbesserte Produktkontrolle erreicht. Ein weiterer Vorteil ist eine höhere Glaubwürdigkeit bzw. Zuverlässigkeit der Bestimmung von cp- und cpk-Werten des Herstellungsprozess. Aus dieser höheren Zuverlässigkeit der Bestimmung resultiert wiederum die Möglichkeit eines gezielteren Eingriffes in den Produktionsablauf insbesondere eine verbesserte Steuerungsmöglichkeit des Prozessverlaufes.

Auch wenn die Erfindung im Weiteren an dem Beispiel eines Überwachungsverfahrens eines Wafer-Herstellungsverfahrens näher erläutert wird, ist darauf hinzuweisen, dass die Erfindung nicht auf ein Waferherstellungsverfahren beschränkt ist, sondern in allen Überwachungsverfahren für Herstellungsverfahren, bei welchen im Herstellungsverfahren zum Herstellen eines physikalischen Objektes Prozessparameter aufgenommen werden, eingesetzt werden kann, beispielsweise auch in der Pharma-Industrie bei dem Herstellen von pharmazeutischen Produkten.

Ein Ausführungsbeispiel der Erfindung ist in den Figuren dargestellt und wird im Weiteren näher erläutert.

Es zeigen:
- Figur 1: ein Blockdiagramm, in welchem die allgemeine Organisation einer Chip-Produktionsanlage dargestellt ist;
- Figur 2: eine Skizze einer Chip-Produktionsanlage, wobei der komplexe Materialfluss, d.h. der Weg eines Wafers/Loses durch die Chip-Produktionsanlage und die damit vorhandenen komplexen Prozessschritte dargestellt ist;
- Figur 3: ein Blockdiagramm, in dem der Prozessdatenfluss bei dem Herstellen eines Wafers/Loses dargestellt ist; und
- Figur 4: eine Verteilung von Werten eines Prozessparameters, welcher bei einer statistischen Analyse als Auswahlkriterium herangezogen wird.

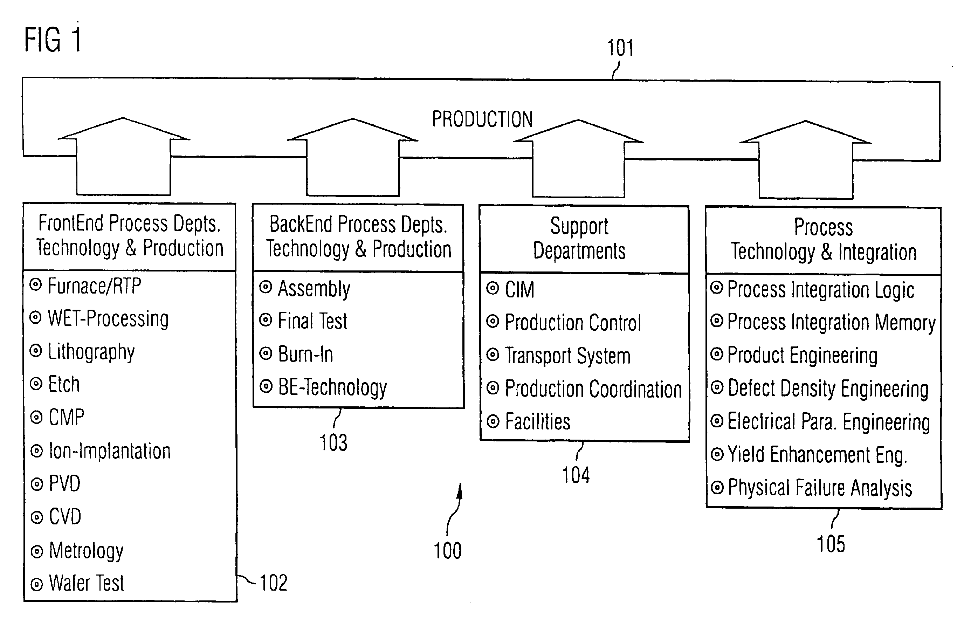

Einleitend wird in **Fig. 1** in einem Blockdiagramm 100 schematisch die Organisation und der Aufbau einer Halbleiterchip-Produktionsanlage, für welche ein erfindungsgemäßes Verfahren zum Überwachen eines Herstellungsprozesses einer Mehrzahl von Wafern verwendet werden kann, erläutert.

Der gesamte Herstellungsprozess, in Fig. 1 mit einem ersten Block 101 bezeichnet, wird beispielhaft in vier Produktionsbereiche 102, 103, 104, 105 gruppiert,
- einen ersten Bereich, in den die Front-End-Prozesse der Chip-Fertigung gruppiert werden (Block 102),
- einen zweiten Bereich des Herstellungsprozesses, in den die Back-End-Prozesse gruppiert werden (Block 103),
- einen dritten Bereich des Herstellungsprozesses, der den Support betrifft, das heißt die Unterstützung der einzelnen Herstellungsprozesse (Block 104),
- ein vierter Bereich der die Prozesstechnologie und die Prozessintegration betrifft (Block 105).

Bei den Front-End-Prozessen 102 sind insbesondere folgende Prozesstechnologien sowie die für die Durchführung der entsprechenden Prozesse eingerichteten Vorrichtungen vorgesehen:
- Ein Ofen zum Erhitzen des jeweiligen zu prozessierenden Wafers,
- eine Vorrichtung zum Durchführen eines Kurzzeit-Temperverfahrens (Rapid Thermal Processing, RTP),
- eine Vorrichtung zum Ätzen des Wafers, beispielsweise zum Nassätzen oder zum Trockenätzen,
- eine Vorrichtung zum Reinigen, beispielsweise Waschen des Wafers,
- eine Vorrichtung zur Durchführung unterschiedlicher Lithographieschritte,
- eine Vorrichtung zum chemisch-mechanischen Polieren (Chemical Mechanical Polishing, CMP),
- eine Einrichtung zur Durchführung einer Ionen-Implantation in vorgegebenen Bereichen des Wafers bzw. des jeweils zu fertigenden Chips,
- Vorrichtungen zum Aufbringen von Materialien auf dem Wafer, beispielsweise Vorrichtungen zum Abscheiden von Materialien aus der Gasphase, das heißt beispielsweise Vorrichtungen zum Durchführen von Physical Vapour Deposition (PVD) oder Chemical Vapour Deposition (CDV), oder eine Vorrichtung zum epitaktischen Aufwachsen von Material auf einem Substrat,
- Metrologie-Vorrichtungen, d.h. Messvorrichtungen,
- Vorrichtungen zum Durchführen von Tests auf den jeweiligen Wafern.

Die Back-End-Prozesse betreffen insbesondere folgende Bereiche:
- Den Zusammenbau der Chips in Gehäuse,
- den Endtest des gefertigten und gehäusten Chips,
- das Einbringen von Informationen, beispielsweise Produktinformation, in oder an das Gehäuse des jeweiligen Chips, sowie
- allgemein die im Bereich des Back-Ends für gehäuste und ungehäuste Chip eingesetzten Technologien.

Der Support, das heißt die Prozessunterstützung betrifft insbesondere folgende Bereiche:
- CIM,
- Prozessüberwachung,
- ein Transportsystem zur Auslieferung der gefertigten Halbleiterchips,
- eine Koordination der Produktion,
- die Unterstützung der jeweiligen Fertigungsstandorte.
   Die Prozesstechnologie und die Prozessintegration betrifft insbesondere
- die Prozessintegration von Logikbausteinen,
- die Prozessintegration von Speicherbausteinen,
- das Produkt-Engineering,
- das Überwachen und Verbessern von Fehlerdichten bei der Herstellung,
- das Überwachen elektrischer Parameter bei den hergestellten Produkten,
- die Verbesserung der Ausbeute der hergestellten Chips,
- eine physikalische Fehleranalyse.

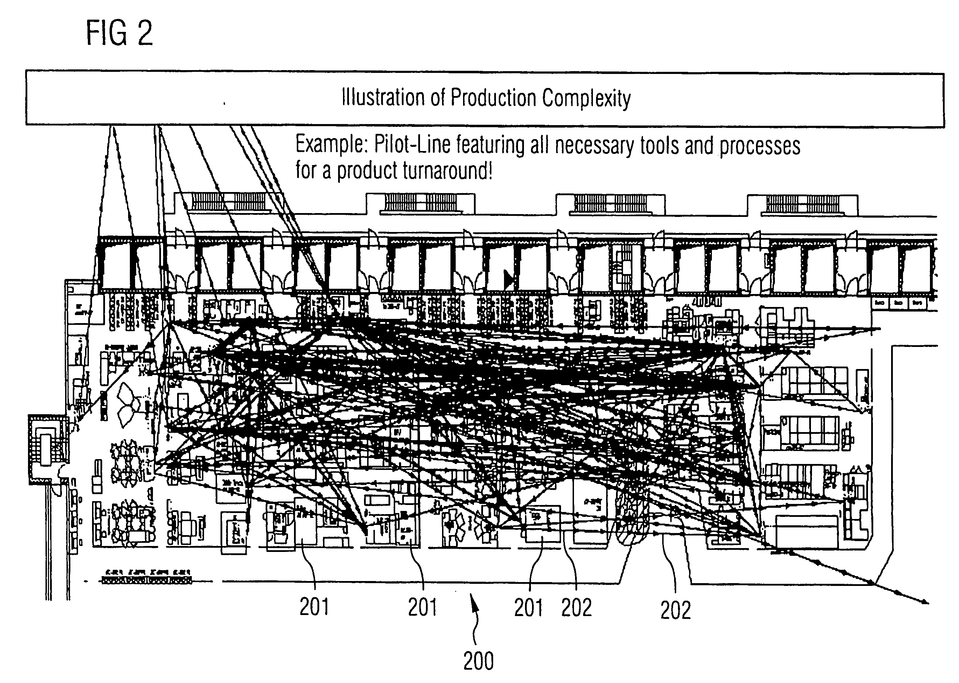

**Fig. 2** zeigt eine Halbleiterchip-Produktionsanlage, anders ausgedrückt eine Halbleiterchip-Fabrik 200 mit einer Vielzahl von Halbleiterchip-Teil-Produktionsanlagen 201, welche eingesetzt werden zur Bearbeitung von Rohmaterialien, beispielsweise eines Siliziumwafers oder eines Wafers aus anderen Halbleiter-Materialien (Germanium, Gallium-Arsenid, Indium-Phosphid, etc.), um aus den Rohmaterialien Halbleiterchips zu fertigen.

Ein üblicher Herstellungsprozess zur Herstellung eines Halbleiterchips weist Hunderte von unterschiedlichen Prozessschritten auf, bei denen in unterschiedlicher Reihenfolge Lithographieschritte, Ätzschritte, CMP-Schritte, Schritte des Aufbringens von Materialien auf dem jeweiligen zu prozessierenden Wafer, oder auch Dotierungs- oder Implantationsschritte von Dotierungsatomen in den zu prozessierenden Wafer durchgeführt werden. Bei all diesem Prozessschritten werden Werte von Prozessparametern aufgenommen, welche einer späteren statistischen Analyse unterworfen werden können.

Somit ergeben sich die in Fig. 2 durch Linien 202 dargestellten Wege, welche den Weg eines Wafers oder eines Loses durch die Halbleiterchip-Produktionsanlage 200 darstellen. In der Halbleiterchip-Produktionsanlage 200 ist eine Vielzahl von Sensoren, welche den jeweiligen Teil-Produktionsanlagen 201 zugeordnet sind und eine noch größere Menge von Prozessdaten (Rohdaten) werden aufgenommen, welche jeweils von den Sensoren erfasst werden und, wie im Weiteren näher erläutert wird, verarbeitet werden. Ein jeweiliger Sensor kann in eine jeweilige Maschine integriert sein (integrierter Sensor) oder separat an eine jeweilige Maschine angebaut sein (externer Sensor).

Im Weiteren werden die Teil-Produktionsanlagen 201 auch als Maschinen 201 bezeichnet.

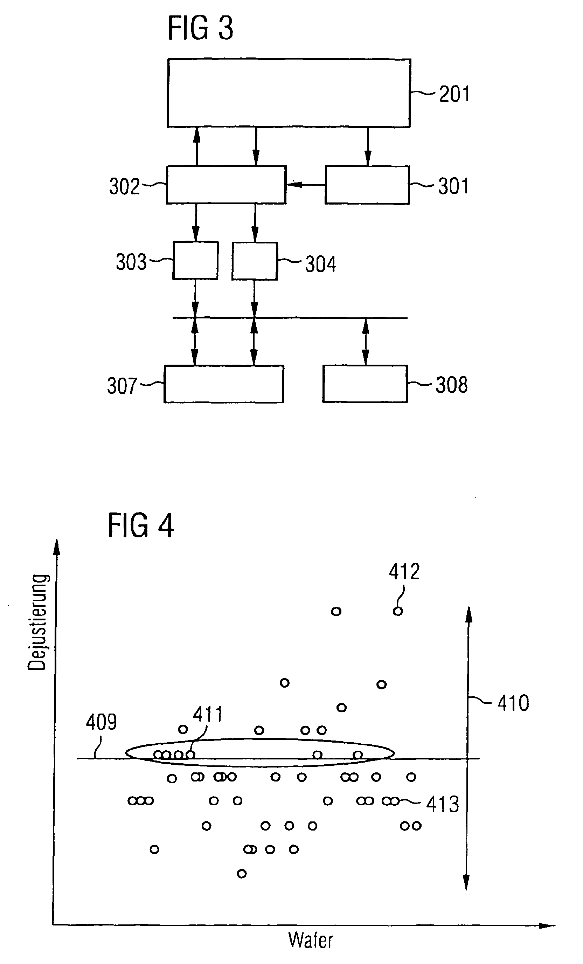

**Fig. 3** zeigt beispielhaft den Datenfluss für Prozessdaten, welche an einer Maschine 201 mittels eines integrierten oder mittels eines externen Sensors 301. Jeder Sensor 301, wobei eine beliebige Anzahl integrierter und/oder externer Sensoren vorgesehen sein können, erfasst die jeweils für ihn vorgegebenen Parameter der Maschine 201, beispielsweise physikalische oder chemische Zustände in einer Prozesskammer, die Position eines Roboterarms, etc. Beispiele für Prozessparameter bei der Herstellung eines Wafers sind zum Beispiel die Dejustierung, d.h. die PositionierungsUngenauigkeit, innerhalb eines Positionierungsschrittes, Temperatur während eines Prozessschrittes, Gasfluss während eines Prozessschrittes, Zeitdauer eines Prozessschrittes oder der Druck während eines Prozessschrittes.

Der Sensor 301 ist über eine SECS-Schnittstelle 302, die eingerichtet ist zur Datenkommunikation gemäß den SECS-Standards mit einem lokalen Kommunikationsnetz (Local Area Network, LAN) 306 gekoppelt.

Gemäß den SECS-Standards werden von dem Sensor 301 und der SECS-Schnittstelle 302 Dateien gemäß dem PDSF-Format (Process Data Standard Format) erzeugt, im Weiteren auch bezeichnet als PDSF-Dateien 303 sowie Protokolldateien 304, wobei die PDSF-Dateien 303 und die Protokolldateien 304 als Daten in einem Speicher 307 gespeichert werden.

Die PDSF-Dateien 303 enthalten z.B. analoge Daten von unterschiedlichen Kanälen, das heißt von unterschiedlichen internen (d.h. integrierten) und/oder externen Sensoren 301, welche an einer Maschine 201 angebracht sein können. Die erzeugten Prozessdaten werden in dem Speicher 307 gespeichert.

Die Speicher 307 speichert die Prozessdaten so, dass sie nach Fertigstellung der Wafer den Wafern zugeordnet werden können, und stellt die Prozessdaten einer späteren statistischen Analyse zur Verfügung. Die statistische Analyse wird mittels einer Auswerteeinheit 308 durchgeführt. Die statistische Analyse der Auswerteeinheit 308 dient dazu ein Auswahlkriterium bereitzustellen, mit dessen Hilfe eine Stichprobe an Wafern eines Loses der Produktion bestimmt werden kann, welche Stichprobe einer nachfolgenden Qualitätskontrollmessung (SPC-Messung) unterzogen wird.

In **Fig. 4** ist eine Verteilung der Werte eines Prozessparameters dargestellt, welcher in dem Herstellungsprozess eines Wafers aufgenommen wurden. Als Beispiel wurde ein Prozessparameter gewählt, welcher die Dejustage oder das so genannte Alignment, d.h. die Abweichung in X- und/oder Y-Richtung von einer Sollposition des Wafers, welche Sollposition er bei der Prozessierung einnehmen soll, zeigt. Die dargestellten Prozessdaten sind On-Line Prozessdaten eines Loses in der Lithographie. Die Prozessdaten werden beim Herstellungsprozess von einer Belichtungsmaschine erfasst und mittels eines LAN-Netzes übermittelt. Die in Fig. 4 zu sehende Streuung der Werte der des Prozessparameters zeigt die natürliche Prozessstreuung, d.h. die Streuung der Justagequalität der Wafer, an.

Der Wert der Dejustage wird als Prozessparameter wie oben beschrieben für jeden Wafer bestimmt. Er steht also ohne weitere zeit- und kostenaufwendige Messung zur Verfügung. Mittels einer statistischen Analyse wird die Verteilung der Werte der Dejustage aller Wafer eines Loses erstellt, welches mittels einer Qualitätsüberwachungsprüfung charakterisiert werden soll.

Im Ausführungsbeispiel werden in der statistischen Analyse die Dejustagewerte (Prozessparameter) aller Wafer in ein Diagramm eingetragen. Somit ergibt sich ein zweidimensionales Histogramm, in welchem die Dejustagewerte der Wafer gegen die Wafernummern aufgetragen sind. Weiter wird mittels der statistischen Analyse der Mittelwert bzw. Median des Prozessparameters aller Wafer des Loses berechnet und ebenfalls in die zweidimensionale Verteilung eingetragen. Anhand dieser zweidimensionalen Verteilung und dem entsprechenden Grenzwert lässt sich nun mittels der Analyse untersuchen, welche Wafer besonders geeignet sind das Los zu charakterisieren.

In Fig. 4 sind die Werte für ein Los aus 50 Wafern eingetragen. Mittels der Analyse werden dann die Wafer bestimmt, welche das Los in diesem Prozessparameter am besten charakterisieren. An einer Stichprobe der Wafer, welche das Los am besten charakterisieren, werden dann nachfolgend Testmessungen durchgeführt, welche die Qualität des Wafers und damit die Qualität des gesamten Loses charakterisieren. Im Ausführungsbeispiel ist der Mittelwert aller Dejustagewerte als horizontale Linie 409 eingetragen. Zusätzlich ist die Streubreite 410 der Verteilung eingetragen. Für die Testmessung wird eine Stichprobe, im allgemeinen ein einzelner Wafer, ausgewählt, welcher in seinem Dejustagewert nahe am Mittelwert der Verteilung liegt. In der Fig. 4 ist dies z.B. der Wafer 411. Mit der Auswahl des Wafers 411 ist sichergestellt, dass ein typischer Vertreter des Loses zur Charakterisierung des gesamten Loses herangezogen wird. Als weiteres Auswahlkriterium neben dem eingezeichneten Mittelwert könnte auch der Median der Verteilung herangezogen werden. Der Median hat gegenüber dem arithmetischen Mittelwert den Vorteil, dass der Median nicht so stark von Wafern, deren Werte für den verwendeten Prozessparameter stark vom Mittelwert der Prozessdaten der anderen Wafer abweichen, beeinflusst wird. D.h. beim Berechnen des Medians fallen Ausreißer der Werte des Prozessparameters nicht so stark ins Gewicht wie bei der Berechnung des Mittelwertes. Somit ergibt sich bei Verwendung des Medians als Auswahlkriterium für die Auswahl der Stichprobe eine verbesserte Aussage über die Qualität der Wafer eines Loses.

Gemäß diesem Ausführungsbeispiel wird zusätzlich zu der durchschnittlichen Qualität des Loses auch noch die Streuung der Produktionsqualitäten untersucht. Hierzu wird zusätzlich zu der Stichprobe aus der Mitte der Verteilung noch eine Stichprobe aus dem Rand der Verteilung einer Testmessung unterzogen. In Fig. 4 wäre dies z.B. der Wafer 412. Wobei hierbei als Streubreite der maximale Abstand des Prozessparameters vom Mittelwert des Prozessparameters angenommen wird. Alternativ kann z.B. auch ein 1σ-Bereich um den Mittelwert der Verteilung als Streubreite angenommen werden. Dies würde in der in Fig. 4 gezeigten Verteilung z.B. dem Wafer 413 entsprechen.

Mittels einer Qualitätsuntersuchungsmessung der beiden Wafer 411 und 412 lassen sich nun repräsentative Aussagen über das gesamte Los erhalten. Die gilt sowohl für den Mittelwert der Verteilung als auch über die Streubreite der Verteilung. Es können aussagekräftige cp-Werte bzw. cpk-Werte des Herstellungsverfahrens erlangt werden. Es lässt sich also auf einfache Weise ein gesamtes Los von Wafern hinsichtlich seiner Qualitätseigenschaften untersuchen. Die benötigte Anzahl von zeit- und kostenintensiven Testmessungen ist minimiert.

Wenn anhand der On-line Daten der Prozessparameter ersichtlich ist, dass gegenüber einer Testmessung, welche Testmessung an mittels des selben Herstellungsprozesses erzeugten Wafern durchgeführt wurde, keine Änderung im Herstellungsprozess aufgetreten sind, kann die Zahl der Wafer, welche einer Testmessung unterzogen werden, weiter verringert werden.

Zusammenfassend schafft die Erfindung ein Verfahren und eine Vorrichtung zum Überwachen der Produktionsqualität eines physikalischen Objektes in einem Herstellungsprozess, bei dem mittels aufgenommener Daten von Prozessparametern und einer statistischen Analyse eine Stichprobe von physikalischen Objekten ausgewählt wird, welche Stichprobe einer anschließenden Testmessung zum Bestimmen der Qualität des physikalischen Objektes verwendet wird. Mittels dieser SPC-Messung kann anschließend das gesamte Los charakterisiert werden. Das erfindungsgemäße Verfahren hat gegenüber dem Stand der Technik den Vorteil, dass mit einem geringen Aufwand an Testmessungen eine fundierte Aussage über die Produktionsqualität eines gesamten Loses getroffen werden kann. Vorteile des erfindungsgemäßen Verfahrens sind also z.B. ein Verringern der Anzahl der benötigten Stichprobenmessungen und damit eine Verringerung des Maschinenkapazitätsbedarfes, ein Verbessern der Prozess- und Produktkontrolle und eine höhere Automatisierung der Stichprobenauswahl. Das erfindungsgemäße Verfahren erlaubt eine aktive Stichprobenauswahl aufgrund von Prozessdaten. Mittels des Verfahrens wird die Gesamtheit eines Loses charakterisiert und nicht nur eine mehr oder weniger repräsentative Stichprobe.

Wenn On-line Messwerte eines Herstellungsprozesses zur Überwachung des Herstellungsprozesses ausgewertet werden, wie dies zum Beispiel bei APC (Advanced Process Control) der Fall ist, ist es möglich anzugeben, welcher Wafer die Verteilung der On-line Messwerte besonders gut charakterisiert.

In diesem Dokument sind folgende Dokumente zitiert:
[1] C.K. Lakshminarayan, "Overview of outlier methods in SC. manufacturing", TI Technical Journal 1998
[2] US 5 422 724
[3] DE 198. 47 631 A1
[4] US 6 233 494 B1

### Bezugszeichenliste

- 100: schematisches Blockdiagramm eines Aufbaus einer Halbleiter-Produktionsanlage
- 101: Block eines gesamten Herstellungsprozesses
- 102: Block eines ersten Produktionsbereiches
- 103: Block eines zweiten Produktionsbereiches
- 104: Block eines dritten Produktionsbereiches
- 105: Block eines vierten Produktionsbereiches
- 200: Halbleiterchip-Produktionsanlage
- 201: Vielzahl von Halbleiterchip-Teil-Produktionsanlagen
- 202: Weg eines Wafers oder Loses durch die Halbleiterchip-Produktionsanlage
- 201: Maschine
- 301: Sensor
- 302: SECS-Schnittstelle
- 303: PDSF-Datei
- 304: Protokolldatei
- 306: lokales Kommunikationsnetz (LAN)
- 307: Speicher
- 308: Auswerteeinheit
- 409: Mittelwert der Dejustagewerte eines Loses
- 410: Streubreite der Verteilung
- 411: Wafer nahe am Mittelwert der Verteilung
- 412: Wafer maximalen Abstandes zum Mittelwert
- 413: Wafer am Rande des 1 σ-Bereiches der Verteilung

## Patentansprüche

1. Verfahren zum Überwachen eines Herstellungsprozesses einer Mehrzahl von physikalischen Objekten,
bei dem eine Analyse unter Verwenden von Werten von mindestens einem Prozessparameter des Herstellungsprozesses der physikalischen Objekte vorgenommen wird;
bei dem als Ergebnis der Analyse ein erstes physikalisches Objekt (411) und ein zweites physikalisches Objekt (413) derart **gekennzeichnet** werden, dass die beiden physikalischen Objekte als Stichprobe für die Überwachung des Herstellungsprozesses heranzuziehen sind, und
dass die beiden physikalischen Objekte (411, 413) einer Qualitätsüberprüfungsmessung zum Überprüfen der Qualität der Mehrzahl physikalischer Objekte unterzogen werden,
**gekennzeichnet dadurch, dass** das erste physikalische Objekt (411) einen Prozessparameterwert aufweist, der die Prozessparameterwerte der Mehrzahl physikalischer Objekte charakterisiert,
und dass das zweite physikalische Objekt (413) einen Prozessparameterwert aufweist, der eine vorgegebene Differenz zum Prozessparameterwert des ersten physikalischen Objekts (411) aufweist.

2. Verfahren gemäß Anspruch 1, bei dem das physikalische Objekt ein Wafer ist.

3. Verfahren gemäß Anspruch 1 oder 2, bei dem die Analyse eine statistische Analyse ist.

4. Verfahren gemäß einem der Ansprüche 1 bis 3, bei dem die Werte des mindestens einen Prozessparameters beim Herstellen des physikalischen Objektes gemessen werden.

5. Verfahren gemäß einem der Ansprüche 1 bis 4, bei dem die Streubreite der Qualitäten der physikalischen Objekte aus den Prozessparameterwerten des ersten und des zweiten physikalischen Objekts (411, 413) berechnet wird.

6. Verfahren gemäß Anspruch 1 oder 5, bei dem die Analyse in der Ermittlung des Medians der Werte des mindestens einen Prozessparameters besteht.

7. Verfahren gemäß Anspruch 1 oder 6, bei dem die Analyse in der Ermittlung des arithmetischen Mittelwertes der Werte des mindestens einen Prozessparameters besteht.

8. Vorrichtung zum Überwachen eines Herstellungsprozesses einer Mehrzahl von physikalischen Objekten mit einem Prozessor, der derart eingerichtet ist, dass folgende Verfahrensschritte durchführbar sind:
Vornehmen einer Analyse unter Verwenden von Werten von mindestens einem Prozessparameter des Herstellungsprozesses der physikalischen Objekte;
Kennzeichnen eines ersten physikalischen Objekts (411) und eines zweiten physikalischen Objekts (413) so dass die beiden physikalischen Objekte als Stichprobe heranzuziehen sind, und
Unterziehen der beiden physikalischen Objekte (411, 413) einer Qualitätsüberprüfungsmessung zum Überprüfen der Qualität der Mehrzahl physikalischer Objekte,
**gekennzeichnet dadurch, dass** das erste physikalische Objekt (411) einen Prozessparameterwert aufweist, der die Prozessparameterwerte der Mehrzahl physikalischer Objekte charakterisiert,
und dass das zweite physikalische Objekt (413) einen Prozessparameterwert aufweist, der eine vorgegebene Differenz zum Prozessparameterwert des ersten physikalischen Objekts (411) aufweist.

9. Computerlesbares Speichermedium, in dem ein Programm zum Überwachen eines Herstellungsprozesses einer Mehrzahl von physikalischen Objekten gespeichert ist, das, wenn es von einem Prozessor ausgeführt wird, folgende Verfahrensschritte aufweist:
Vornehmen einer Analyse unter Verwenden von Werten von mindestens einem Prozessparameter des Herstellungsprozesses der physikalischen Objekte;
Kennzeichnen eines ersten physikalischen Objekts (411) und eines zweiten physikalischen Objekts (413) so dass die beiden physikalischen Objekte als Stichprobe heranzuziehen sind, und
Unterziehen der beiden physikalischen Objekte (411, 413) einer Qualitätsüberprüfungsmessung zum Überprüfen der Qualität der Mehrzahl physikalischer Objekte,
**gekennzeichnet dadurch, dass** das erste physikalische Objekt (411) einen Prozessparameterwert aufweist, der die Prozessparameterwerte der Mehrzahl physikalischer Objekte charakterisiert,
und dass das zweite physikalische Objekt (413) einen Prozessparameterwert aufweist, der eine vorgegebene Differenz zum Prozessparameterwert des ersten physikalischen Objekts (411) aufweist.

10. Computerprogramm-Element zum Überwachen eines Herstellungsprozesses einer Mehrzahl von physikalischen Objekten, das, wenn es von einem Prozessor ausgeführt wird, folgende Verfahrensschritte aufweist:
Vornehmen einer Analyse unter Verwenden von Werten von mindestens einem Prozessparameter des Herstellungsprozesses der physikalischen Objekte;
Kennzeichnen eines ersten physikalischen Objekts (411) und eines zweiten physikalischen Objekts (413) so dass die beiden physikalischen Objekte als Stichprobe heranzuziehen sind, und
Unterziehen der beiden physikalischen Objekte (411, 413) einer Qualitätsüberprüfungsmessung zum Überprüfen der Qualität der Mehrzahl physikalischer Objekte,
**gekennzeichnet dadurch, dass** das erste physikalische Objekt (411) einen Prozessparameterwert aufweist, der die Prozessparameterwerte der Mehrzahl physikalischer Objekte charakterisiert,
und dass das zweite physikalische Objekt (413) einen Prozessparameterwert aufweist, der eine vorgegebene Differenz zum Prozessparameterwert des ersten physikalischen Objekts (411) aufweist.

## Claims

1. A method for the monitoring of a manufacturing process of a plurality of physical objects,
in which an analysis is performed by using values of at least one process parameter of the manufacturing process of the physical objects;
in which, as a result of the analysis, a first physical object (411) and a second physical object (413) are marked in such a way that both physical objects are to be taken as a random sample for the monitoring of the manufacturing process; and
that both physical objects (411, 413) are subjected to a quality checking measurement for checking the quality of the plurality of physical objects;
**characterized in that** the first physical object (411) comprises a process parameter value characterizing the process parameter values of the plurality of physical objects;
and that the second physical object (413) comprises a process parameter value having a prescribed difference to the process parameter value of the first physical object (411).

2. The method as claimed in claim 1, in which the physical object is a wafer.

3. The method as claimed in claim 1 or 2, in which the analysis is a statistical analysis.

4. The method as claimed in one of claims 1 to 3, in which the values of the at least one process parameter are measured when the physical object is being manufactured.

5. The method as claimed in one of claims 1 to 4, in which the variation of the qualities of the physical objects is calculated from the process parameter values of the first and second physical objects (411, 413).

6. The method as claimed in claim 1 or 5, in which the analysis comprises the ascertainment of the median of the values of the at least one process parameter.

7. The method as claimed in claim 1 or 6, in which the analysis comprises the ascertainment of the arithmetic mean value of the values of the at least one process parameter.

8. A device for the monitoring of a manufacturing process of a plurality of physical objects with a processor which is set up in such a way that the following method steps can be carried out:
performance of an analysis by using values of at least one process parameter of the manufacturing process of the physical objects;
marking of a first physical object (411) and a second physical object (413) in such a way that both physical objects are to be taken as a random sample; and
subjecting both physical objects (411, 413) to a quality checking measurement for checking the quality of the plurality of physical objects;
**characterized in that** the first physical object (411) comprises a process parameter value characterizing the process parameter values of the plurality of physical objects;
and that the second physical object (413) comprises a process parameter value having a prescribed difference to the process parameter value of the first physical object (411).

9. A computer-readable storage medium, in which a program for the monitoring of a manufacturing process of a plurality of physical objects is stored, which program has the following method steps when it is run by a processor:
performance of an analysis by using values of at least one process parameter of the manufacturing process of the physical objects;
marking of a first physical object (411) and a second physical object (413) in such a way that both physical objects are to be taken as a random sample; and
subjecting both physical objects (411, 413) to a quality checking measurement for checking the quality of the plurality of physical objects;
**characterized in that** the first physical object (411) comprises a process parameter value characterizing the process parameter values of the plurality of physical objects;
and that the second physical object (413) comprises a process parameter value having a prescribed difference to the process parameter value of the first physical object (411).

10. A computer program element for the monitoring of a manufacturing process of a plurality of physical objects, which has the following method steps when it is run by a processor:
performance of an analysis by using values of at least one process parameter of the manufacturing process of the physical objects;
marking of a first physical object (411) and a second physical object (413) in such a way that both physical objects are to be taken as a random sample; and
subjecting both physical objects (411, 413) to a quality checking measurement for checking the quality of the plurality of physical objects;
**characterized in that** the first physical object (411) comprises a process parameter value characterizing the process parameter values of the plurality of physical objects;
and that the second physical object (413) comprises a process parameter value having a prescribed difference to the process parameter value of the first physical object (411).

## Revendications

1. Procédé de contrôle d'un processus de fabrication d'une multiplicité d'objets physiques,
dans lequel on effectue une analyse en utilisant des valeur d'au moins un paramètre du processus de fabrication des objets physiques ;
dans lequel comme résultat de l'analyse on caractérise un premier objet (411) physique et un deuxième objet (413) physique de façon à ce que les deux objets physiques soient mis à profit en tant qu'échantillons pour le contrôle du processus de fabrication, et
on soumet les deux objets (411, 413) physiques à une mesure de contrôle de qualité pour contrôler la qualité de la pluralité des objets physiques,
**caractérisé en ce que** le premier objet (411) physique a une valeur de paramètre de processus, qui caractérise les valeurs de paramètre de processus de la multiplicité d'objets physiques,
et **en ce que** le deuxième objet (413) physique a une valeur de paramètre de processus, qui a une différence prescrite par rapport à la valeur de paramètre de processus du premier objet (411) physique.

2. Procédé suivant la revendication 1, dans lequel l'objet physique est une tranche.

3. Procédé suivant la revendication 1 ou 2, dans lequel l'analyse est une analyse statistique.

4. Procédé suivant l'une des revendications 1 et 3, dans lequel on mesure les valeurs du au moins un autre paramètre de processus lors de la fabrication de l'objet physique.

5. Procédé suivant l'une des revendications 1 à 4, dans lequel on calcule la dispersion des qualités des objets physiques à partir des valeur de paramètre de processus du premier et du deuxième objet (411, 413) physique.

6. Procédé suivant la revendication 1 ou 5, dans lequel l'analyse consiste en la détermination de la médiane des valeurs du au moins un paramètre de processus.

7. Procédé suivant la revendication 1 ou 6, dans lequel l'analyse consiste en la détermination de la moyenne arithmétique des valeurs du au moins un paramètre de processus.

8. Dispositif de contrôle d'un processus de fabrication d'une multiplicité d'objets physiques par un processeur qui est tel qu'il peut effectuer des stades de procédé suivant :
on effectue une analyse en utilisant des valeur d'au moins un paramètre du processus de fabrication des objets physiques ;
on caractérise un premier objet (411) physique et un deuxième objet (413) physique de façon à ce que les deux objets physiques soient mis à profit en tant qu'échantillons, et
on soumet les deux objets (411, 413) physiques à une mesure de contrôle de qualité pour contrôler la qualité de la pluralité des objets physiques,
**caractérisé en ce que** le premier objet (411) physique a une valeur de paramètre de processus, qui caractérise les valeurs de paramètre de processus de la multiplicité d'objets physiques,
et **en ce que** le deuxième objet (413) physiques a une valeur de paramètre de processus, qui a une différence prescrite par rapport à la valeur de paramètre de processus du premier objet (411) physique.

9. Support de mémoire pouvant être lu par ordinateur, dans lequel est mémorisé un programme de contrôle d'un processus de fabrication d'une multiplicité d'objets physiques qui, lorsqu'il est réalisé par un processeur, a les stades de procédé suivants :
on effectue une analyse en utilisant des valeurs d'au moins un paramètre du processus de fabrication des objets physiques ;
on caractérise un premier objet (411) physique et un deuxième objet (413) physique de façon à ce que les deux objets physiques soient mis à profit en tant qu'échantillons pour le contrôle du processus de fabrication, et
on soumet les deux objets (411, 413) physiques à une mesure de contrôle de qualité pour contrôler la qualité de la pluralité des objets physiques,
**caractérisé en ce que** le premier objet (411) physique a une valeur de paramètre de processus, qui caractérise les valeurs de paramètre de processus de la multiplicité d'objets physiques,
et **en ce que** le deuxième objet (413) physique a une valeur de paramètre de processus, qui a une différence prescrite par rapport à la valeur de paramètre de processus du premier objet (411) physique.

10. Elément de programme informatique pour le contrôle d'un processus de fabrication d'une multiplicité d'objets physiques qui, lorsqu'il est réalisé par un processeur, a les stades de procédés suivants :
on effectue une analyse en utilisant des valeurs d'au moins un paramètre du processus de fabrication des objets physiques ;
on caractérise un premier objet (411) physique et un deuxième objet (413) physique de façon à ce que les deux objets physiques soient mis à profit en tant qu'échantillons pour le contrôle du processus de fabrication, et
on soumet les deux objets (411, 413) physiques à une mesure de contrôle de qualité pour contrôler la qualité de la pluralité des objets physiques,
**caractérisé en ce que** le premier objet (411) physique a une valeur de paramètre de processus qui caractérise les valeur de paramètre de processus de la multiplicité d'objets physiques,
et **en ce que** le deuxième objet (413) physique a une valeur de paramètre de processus qui a une différence prescrite par rapport à la valeur de paramètre de processus du premier objet (411) physique.
